**Europäisches Patentamt**

**European Patent Office**

**Office européen des brevets**

(19)

(11) Publication number: **0 066 631**
A1

(12) # EUROPEAN PATENT APPLICATION

published in accordance with Art. 158(3) EPC

(21) Application number: **82900046.2**

(22) Date of filing: **16.12.81**

Data of the international application taken as a basis:

(86) International application number:
**PCT/JP 81/00387**

(87) International publication number:
**WO 82/02137 (24.06.82 82/16)**

(51) Int. Cl.³: **H 05 K 3/30**

(30) Priority: **18.12.80 JP 179779/80**

(43) Date of publication of application: **15.12.82**
**Bulletin 82/50**

(84) Designated Contracting States: **DE FR GB**

(71) Applicant: **Matsushita Electric Industrial Co., Ltd., 1006, Oaza Kadoma, Kadoma-shi Osaka-fu, 571 (JP)**

(72) Inventor: **FUJITA, Takayuki, 6-6, Ikagasakaemachi, Hirakata-shi Osaka-fu 573 (JP)**
Inventor: **YOSHIDA, Yoshiaki, 13-18, Hiyoshidainanaban-cho, Takatsuki-shi Osaka-fu 569 (JP)**
Inventor: **HIGASHIURA, Toshiyuki, 21-15 Kuzuhanamiki 1-chome, Hirakata-shi Osaka-fu 573 (JP)**
Inventor: **TANAKA, Kunio, 19-19 Nakakamida, Neyagawa-shi Osaka-fu 572 (JP)**
Inventor: **SHIBATA, Keiji, 107, Yagumokitamachi 2-chome, Moriguchi-shi Osaka-fu 570 (JP)**

(74) Representative: **Eisenführ & Speiser, Martinistrasse 24, D-2800 Bremen 1 (DE)**

(54) **MOUNTING AND TESTING EQUIPMENT FOR LEADLESS ELECTRONIC PARTS.**

(57)    Mounting and testing equipment for leadless electronic parts, wherein a mounting member (6) mounts a leadless electronic part (1) after a printed circuit board (2) is fed onto an X-Y table (5), the printed circuit board (2) with the leadless electronic part (1) mounted on it is transported a predetermined distance, and then a testing member (7) tests the mounting state of the leadless electronic part (1) mounted on the printed circuit board (2) while another leadless electronic part (1) is mounted onto the next printed circuit board (2). Operation can thus be made reliable and efficient.

-1-

SPECIFICATION

TITLE OF THE INVENTION

MOUNTING AND INSPECTING APPARATUS FOR LEADLESS ELECTRONIC PARTS

FIELD OF THE INVENTION

The present invention relates to a mounting and inspecting apparatus for leadless electronic parts, wherein leadless electronic parts such as chip type resistors and the like are mounted on a printed circuit board and then, the mounting states of the leadless electronic parts mounted on the printed circuit board are inspected.

BACKGROUND OF THE INVENTION

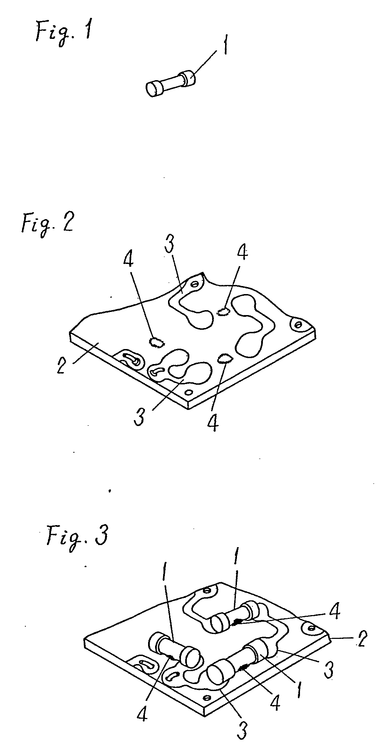

Due to recent developments in the field of leadless electronic parts, it has been so arranged that a leadless electronic part 1 shown in Fig. 1 is mounted between conductive patterns 3 on a printed circuit board 2 with adhesive 4 applied between the conductive patterns 3 by the use of an automatic mounting apparatus as shown in Fig. 3.

Since the leadless electronic parts 1 are barely attached to the printed circuit board 2 through viscosity of the adhesive 4, the leadless electronic parts 1 are liable to be displaced when subjected to an external force such as vibration, impact, etc.

Accordingly, mounting positions of the leadless electronic parts should be inspected prior to curing of the adhesive 4 and thereafter, the adhesive 4 should be cured. However, conventionally it has been a general practice that, after all the leadless electronic parts have been mounted on the printed circuit board 2, the printed circuit board 2 having the leadless electronic parts 1 mounted thereon is taken out so as to undergo a visual inspection, so that the inspection has been extremely troublesome, thereby resulting in low productivity.

DISCLOSURE OF THE INVENTION

Accordingly, the present invention has for its object to provide a mounting and inspecting apparatus for leadless electronic parts, wherein leadless electronic parts are mounted on a printed circuit board after the printed circuit board has been fed onto an X-Y table, the printed circuit board having the leadless electronic parts mounted thereon is transported by a predetermined distance, and then, the mounting states of the leadless electronic parts mounted on the printed circuit board are inspected while another leadless electronic part is mounted onto the next printed circuit board.

BRIEF DESCRIPTION OF THE DRAWINGS

Fig. 1 is a perspective view showing one example of a leadless electronic part,

Fig. 2 is a perspective view of a printed

-3-

circuit board on which the leadless electronic parts are to be mounted,

Fig. 3 is a perspective view of the printed circuit board having the leadless electronic parts mounted thereon,

Fig. 4 is a perspective view of a mounting and inspecting apparatus for leadless electronic parts, according to one embodiment of the present invention,

Fig. 5 is a perspective view of an X-Y table employed in the mounting and inspecting apparatus of Fig. 4,

Fig. 6 is a side elevational view of the X-Y table of Fig. 5,

Fig. 7 is a perspective view of a mounting unit employed in the mounting and inspecting apparatus of Fig. 4, and

Fig. 8 is a cross-sectional view of an inspecting unit employed in the mounting and inspecting apparatus of Fig. 4.

THE BEST PREFERRED EMBODIMENT OF THE INVENTION

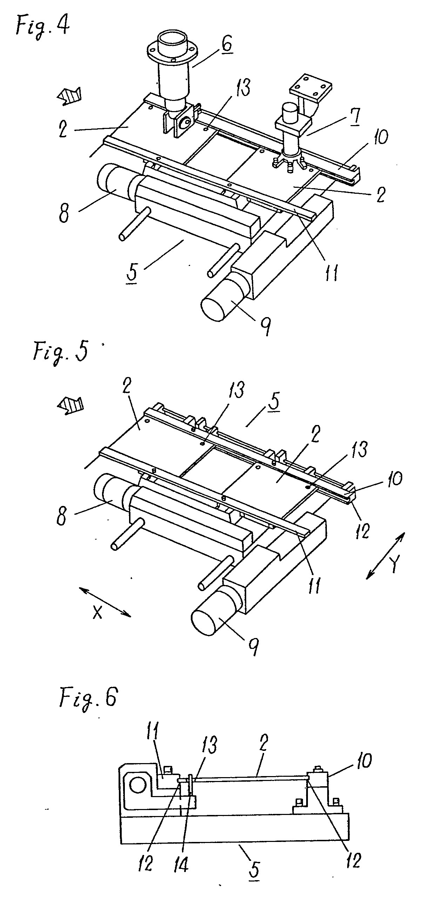

Hereinbelow, one embodiment of the present invention will be described with reference to Figs. 4 to 8.

Firstly, a whole structure of a mounting and inspecting apparatus for leadless electronic parts, according to the present invention will be described with reference to Fig. 4. In Fig. 4, a reference numeral 5 is an X-Y table. A mounting unit 6 and an inspecting unit 7 are provided on the X-Y table 5. As shown in Figs. 5 and 6, it is so arranged that the X-Y table 5 is moved freely in X-axis and Y-axis directions by an X-axis pulse motor 8 and a Y-axis pulse motor 9, respectively. A rail 10 and a rail 11 are provided on the X-Y table 5 so as to be spaced a predetermined distance from each other. Grooves 12 are formed on faces of the rails 10 and 11, which faces confront each other. It is so arranged that the above described printed circuit board 2 is transported into the grooves 12 and then, is positioned by inserting a positioning pin 14 into a reference hole 13 formed on the printed circuit board 2 from below.

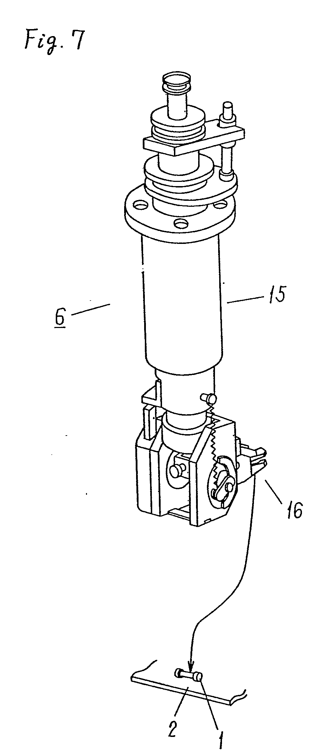

As shown in Fig. 7, the mounting unit 6 is of a multiple shaft structure in which shafts are, respectively, provided with cam follower guides. The mounting unit 6 has a drive control portion 15 adapted to be rotatable and movable vertically, and a chuck 16 adapted to be pivoted through approximate 90° from a horizontal position to a downward position with the chuck 16 being provided at a lower end of the drive control portion 15. Thus, it is so arranged that the chuck 16 holds, at the horizontal position, the leadless electronic part 1 supplied one by one from a part feeding portion, the chuck 16 is pivoted downwardly through approximate 90°, and then, the leadless electronic part 1 is pressed, for mounting thereof, onto a portion of the printed circuit board 2 positioned and held between the rails 10 and 11 with the adhesive 4 being applied to the portion.

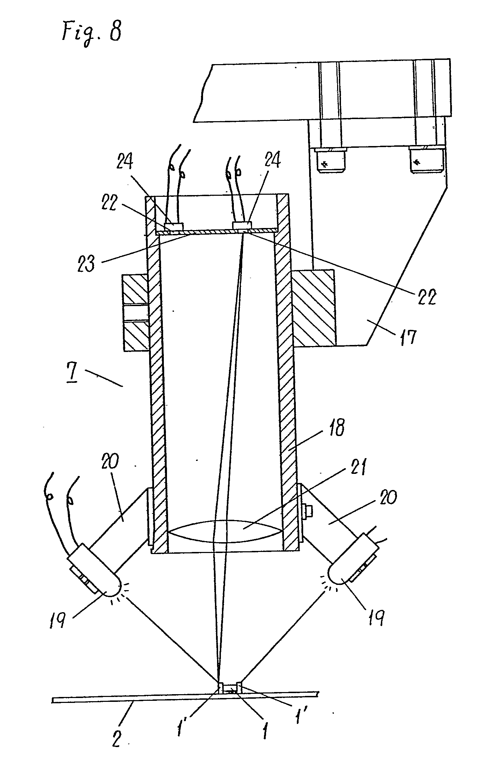

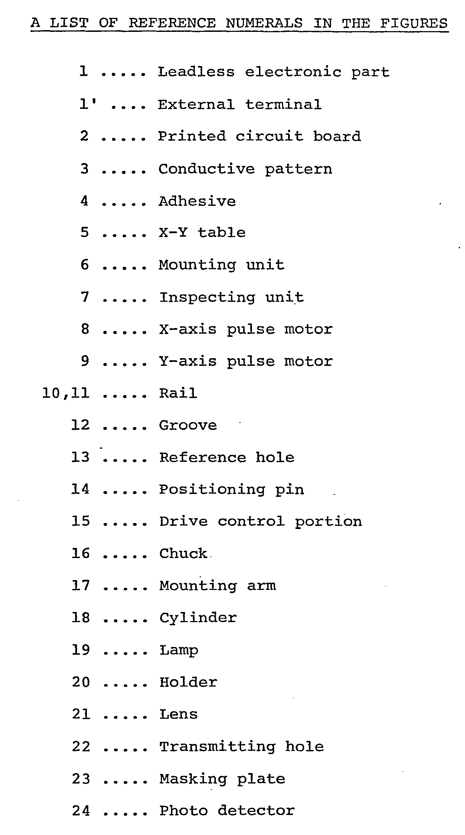

Meanwhile, the inspecting unit 7 is disposed above the printed circuit board 2 having all the leadless electronic parts 1 mounted thereon, which has been transported, for positioning thereof, at a predetermined pitch. The inspecting unit 7 has such a structure as shown in Fig. 8. Namely, a cylinder 18 mounted on a mounting arm 17 has lamps 19 for irradiating the leadless electronic parts 1 mounted on the printed circuit board 2, which lamps 19 are, respectively, attached to a lower periphery of the cylinder 18 through holders 20 so as to be inclined with respect to a central axis of the cylinder 18. A lens 21 is disposed at a lower portion of the cylinder 18, and a masking plate 23 formed with transmitting holes 22 is attached to an upper portion of the cylinder 18. Further, photo detectors 24 are provided on the transmitting holes 22 of the masking plate 23, respectively. When the lamps 19 are turned on so as to irradiate each of the leadless electronic parts 1 obliquely and from above, light is reflected on a circular face of external terminals 1' provided at opposite ends of each of the leadless electronic parts 1 with the external terminals 1' being made of metal, and then, the reflected light passes through the lens 21

-6-

so as to be irradiated on the masking plate 23 as spots of light, so that the spots of light are transmitted through the transmitting holes 22 so as to be incident upon the photo detectors, whereby the respective mounting positions of the leadless electronic parts 1 can be inspected.

It is possible to detect a displacement of the mounting position of each of the leadless electronic parts 1 by fixing the photo detectors 24 to the masking plate 23 and by changing a size of the transmitting holes 22. Since the transmitting holes 22 are provided at positions corresponding to the proper mounting positions of the leadless electronic parts 1, the reflected light is sufficiently incident upon the photo detectors 24 through the transmitting holes 22 in the case where each of the leadless electronic parts 1 is mounted at the proper mounting position, whereby a predetermined output can be obtained from each of amplifiers connected to the photo detectors 24.

On the other hand, in the case where any one of the leadless electronic parts 1 is displaced from the proper mounting position, quantity of light incident upon the photo detectors 24 through the transmitting holes 22 is reduced, so that the light is insufficiently detected by the photo detectors 24 and thus, the predetermined output cannot be obtained from each of the amplifiers connected to the photo detectors 24, whereby the displacement

-7-

of each of the leadless electronic parts 1 from the proper mounting position can be detected.

Meanwhile, if any one of the leadless electronic parts 1 has not been mounted at a position where the leadless electronic part 1 should be normally mounted, no reflected light of the lamps 19 is produced, so that no light is incident upon the photo detectors 24 through the transmitting holes 22 and thus, no output is obtained from the amplifiers connected to the photo detectors 24, whereby absence of the leadless electronic part 1 can be detected.

As is clear from the foregoing, since a printed circuit board 2 ready for mounting thereon of the leadless electronic parts 1 and another printed circuit board 2 having the leadless electronic parts 1 mounted thereon are positioned between the rails 10 and 11 provided on the single X-Y table 5 with a predetermined distance being maintained therebetween, and mounting states of the leadless electronic parts 1 mounted on the printed circuit board 2 by the mounting unit 6 can be inspected by the inspecting unit 7 simultaneously at the time another lead electronic part 1 is mounted onto the next printed circuit board 2 by the mounting unit 6, the mounting states of the leadless electronic parts 1 mounted on the printed circuit board 2 can be inspected remarkably reliably and efficiently.

## UTILIZATION IN INDUSTRIES

As is clear from the foregoing description, in accordance with the mounting and inspecting apparatus for leadless electronic parts, according to the present invention, since mounting and inspection of the leadless electronic parts are performed correspondingly on the single X-Y table, the inspection is reliable and further, can be performed in the same short period of time as a time period required for the mounting, so that the leadless electronic parts can be immediately bonded, through curing of the adhesive, to the printed circuit board taken out of the X-Y table and thus, the leadless electronic parts can be mounted on the printed circuit board remarkably reliably, whereby the mounting and inspecting apparatus of the present invention has such a high industrial value as effectiveness for assembly of electrical circuit units for various electronic appliances, etc.

What is claimed is:

1.        A mounting and inspecting apparatus for leadless electronic parts, by which each of the leadless electronic parts is mounted between conductive patterns of a printed circuit board by the use of adhesive and the mounting states of the leadless electronic parts mounted on the printed circuit board are inspected prior to curing of the adhesive, said mounting and inspecting apparatus comprising:

        a mounting unit for mounting the leadless electronic parts on the printed circuit board held, for positioning thereof, on rails provided on an X-Y table; and

        an inspecting unit for inspecting mounting states of the leadless electronic parts mounted on the printed circuit board, which holds the printed circuit board having the leadless electronic parts mounted thereon by said mounting unit, for positioning thereof;

        said inspecting unit being provided above the printed circuit board having the leadless electronic part mounted thereon so as to be disposed at a position corresponding to the leadless electronic parts.

2.    A mounting and inspecting apparatus as claimed in Claim 1, wherein said inspecting unit comprises a lamp for irradiating the leadless electronic parts, a lens for condensing light which has been reflected by metallic terminals of each of the leadless electronic parts, a masking plate having transmitting holes disposed at positions where spots of light are formed by the reflected light transmitted through said lens, and photo detectors provided, respectively, on said transmitting holes of said masking plate.

Fig. 1

1

Fig. 2

4   3   4

4

2

3   4

Fig. 3

1   1

4

4

2

3

1

4   4

3

− 2/5

**Fig. 4**

**Fig. 5**

**Fig. 6**

Fig. 7

Fig. 8

## A LIST OF REFERENCE NUMERALS IN THE FIGURES

| | | |
|---|---|---|
| 1 | ..... | Leadless electronic part |
| 1' | .... | External terminal |
| 2 | ..... | Printed circuit board |
| 3 | ..... | Conductive pattern |
| 4 | ..... | Adhesive |
| 5 | ..... | X-Y table |
| 6 | ..... | Mounting unit |
| 7 | ..... | Inspecting unit |
| 8 | ..... | X-axis pulse motor |
| 9 | ..... | Y-axis pulse motor |
| 10,11 | ..... | Rail |
| 12 | ..... | Groove |
| 13 | ..... | Reference hole |
| 14 | ..... | Positioning pin |
| 15 | ..... | Drive control portion |
| 16 | ..... | Chuck |
| 17 | ..... | Mounting arm |
| 18 | ..... | Cylinder |
| 19 | ..... | Lamp |
| 20 | ..... | Holder |
| 21 | ..... | Lens |
| 22 | ..... | Transmitting hole |
| 23 | ..... | Masking plate |
| 24 | ..... | Photo detector |

# INTERNATIONAL SEARCH REPORT

International Application No  PCT/JP81/00387

## I. CLASSIFICATION OF SUBJECT MATTER (if several classification symbols apply, indicate all) 3

According to International Patent Classification (IPC) or to both National Classification and IPC

Int. Cl.$^3$   H05K 3/30

## II. FIELDS SEARCHED

### Minimum Documentation Searched 4

| Classification System | Classification Symbols |
| --- | --- |
| I P C | H05K 3/30, H05K 13/08, H05K 1/18, B23P 19/00 |

### Documentation Searched other than Minimum Documentation to the Extent that such Documents are Included in the Fields Searched 5

Kokai Jitsuyo Shinan Koho          (1971 - 1981)

## III. DOCUMENTS CONSIDERED TO BE RELEVANT 14

| Category * | Citation of Document, 16 with indication, where appropriate, of the relevant passages 17 | Relevant to Claim No. 18 |
| --- | --- | --- |
| X | JP,A, 54-41466  (Matsushita Electric Industrial Co., Ltd.)  2, April, 1979  (02.04.79) P344, Column 2, lines 8 to 19 | 1 |
| Y | JP,A, 54-35362  (Toshiba Corp.)  15, March, 1979  (15.03.79),  P324, Column 2, lines 12 to 20 | 2 |
| P | JP,A, 56-38900  (Pioneer Electronic Corp.) 14, April, 1981  (14.04.81)  P. 622, column 4, line 5 to P. 623, column 1, line 9 | 2 |

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

* Special categories of cited documents: 15

"A" document defining the general state of the art

"E" earlier document but published on or after the international filing date

"L" document cited for special reason other than those referred to in the other categories

"O" document referring to an oral disclosure, use, exhibition or other means

"P" document published prior to the international filing date but on or after the priority date claimed

"T" later document published on or after the international filing date or priority date and not in conflict with the application, but cited to understand the principle or theory underlying the invention

"X" document of particular relevance

## IV. CERTIFICATION

| Date of the Actual Completion of the International Search 2 | Date of Mailing of this International Search Report 2 |
| --- | --- |
| March 5, 1982  (05.03.82) | March 23, 1982  (23.03.82) |
| International Searching Authority 1 | Signature of Authorized Officer 20 |
| Japanese Patent Office | |

Form PCT/ISA/210 (second sheet) (October 1977)